# EUROPEAN PATENT SPECIFICATION

(11) **EP 0 283 317 B1**
(45) Date of publication and mention of the grant of the patent: **10.02.1993**
(21) Application number: 88302429.1
(22) Date of filing: 18.03.1988
(51) Int. Cl.: H01L 39/12, H01L 39/24, C04B 35/00

(54) **Superconducting oxide ceramics**
Supraleitende Oxid-Keramiken
Oxydes céramiques superconducteurs

(30) Priority: 18.03.1987 JP 63388/87; 18.03.1987 JP 63389/87; 25.03.1987 JP 72485/87
(43) Date of publication of application: 21.09.1988
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo 157 (JP)
(74) Representative: Milhench, Howard Leslie

(56) References cited:
- EP-A- 0 280 812
- US-A- 3 932 315
- ZEITSCHRIFT FÜR PHYSIK B - CONDENSED MATTER, vol. 64, no 2, 1986, pages 189-193, Springer-Verlag; J.G. BEDNORZ et al.: "Possible high Tc superconductivity in the Ba-La-Cu-O system"

## Description

### BACKGROUND OF THE INVENTION

This invention relates to superconducting oxide ceramics having a high Tc.

The prior art has proposed the use of metals such as mercury and lead, intermetallics such as NbNd, Nb₃Ge and Nb₃Ga, and ternary materials such as Nb₃(Al_{0.8}Ge_{0.2}) as superconductors. Another type of superconducting material, superconductive barium-lead-bismuth oxides, is described in US Patent No. 3,932,315. However, only three-dimensional electron conduction takes place in such conventional superconducting materials, and the critical transition temperature Tc of such conventional superconducting materials cannot therefore exceed 25°K.

In recent years, superconducting ceramics have attracted widespread interest. A new material was first reported by researchers at the Zurich laboratory of IBM Corp. as Ba-La-Cu-O-type high temperature superconducting oxides. Also, La-Sr-Cu(II)-O-type superconducting oxides have been proposed. This type of superconducting material appears to form a quasi-molecular crystalline structure whose unit cell is constructed with one layer in which electrons have essentially one dimensional motion. Such a superconducting material, however, has Tc lower than 30°K.

### SUMMARY OF THE INVENTION

It is therefore an object of the present invention to provide superconducting ceramics having a higher Tc.

The present invention resides in the concept of superconducting oxide ceramic materials which include Ga (Gallium), Zr (Zirconium), Nb (Niobium) and/or Ge (Germanium). By use of these elements, the present invention provides superconducting oxide ceramics which form a new type of molecular (atomic) structure including a K₂NiF₄ type structure.

According to the present invention in one of its aspects there is provided a superconducting oxide ceramic represented by the general formula

(A₁₋ₓBₓ)_{y}Cu_{z}O_{w}

wherein x=0.66, y=2.0-4.0; z=1.0-4.0; w=4.0-10.0; A is one or more of the elements Ga, Zr, Nb and Ge; and B is one or more of the alkaline earth metals.

A superconducting oxide ceramic in accordance with another aspect of the present invention comprises a ceramic represented by the general formula

(A₁₋ₓBₓ)_{y}CuO_{z}

wherein x=0.01-0.3; y=1.3-2.2; z=2.0-4.0; A is one or more of the elements Ga, Zr, Nb and Ge; and B is one or more of the alkaline earth metals.

Both of the abovementioned superconducting oxide ceramics may be modified by substituting for a minor proportion of the element A one or more of the elements Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium) and Y (Yttrium).

According to the present invention in another of its aspects there is provided a method of forming a superconducting oxide ceramic as defined above, said method comprising:
(a) mixing oxides or carbonates of copper, of one or more alkaline earth metals, and of one or more elements selected from the group consisting of Ga, Zr, Nb and Ge in the respective proportions required to form the superconducting oxide material;
(b) compacting the mixture under pressure;
(c) firing the compact mixture;
(d) grinding the fired mixture into powder; and
(e) forming the superconducting oxide ceramic from said powder.

Other features of the present invention are set forth with particularity in the appended claims and, together with the above features, will become clear to those possessed of the relevant skills from consideration of the following detailed description of exemplary embodiments.

### DETAILED DESCRIPTION OF THE EMBODIMENTS

First described hereinafter are a number of examples illustrating the manufacture of superconducting ceramics according to the present invention which conform to the stoichiometric formula:

(A₁₋ₓBₓ)_{y}Cu_{z}O_{w} (i)

wherein x=0.66; y=2.0-4.0; z=1.0-4.0; and w=4.0-10.0; or more preferably y=2.5-3.5; z=1.5-3.5; and w=6.0-8.0; and wherein A represents one or more elements selected from the group consisting of Ga, Zr, Nb and Ge; and B represents one or more elements selected from the alkaline earth metals.

The formula (i) corresponds to superconducting ceramic compositions which appear to have a perovskite-like structure.

### Example 1:

Nb₂O₅, BaCO₃, and CuO all in the form of fine powder and having a purity of 99. 95% or higher were mixed in the proportions required by the above formula (1) with x=0.66 (A:B=1:2); y=3.0; z=3.0; w=6 to 8 and with A being Nb and B being barium. These materials were thoroughly mixed in a mortar, packed into capsules and pressed into tablets of 10mm diameter and 3mm thickness under a pressure of 3 Kg/cm². Then, the tablets were fired for 8 hours at 500-1000°C, for example 700°C, in an oxidizing environment, for example ambient air, this step being called pre-firing hereinafter.

The tablets were then ground in a mortar into a powder having an average particle radius of not larger than 10 microns. The powder was again pressed in capsules under a pressure of 50 Kg/cm² at an elevated temperature to form tablets. The tablets were then fired for 10-50 hours, e.g. for 15 hours, at 500-1000°C, e.g. 900°C, in an oxidizing environment, e.g. ambient air, this step being called main-firing hereinafter. Finally, the tablets were reduced by heating for 3-30 hours, e.g. for 20 hours, at 600-1100°C, e.g. at 800°C, in an oxygen/argon mixture containing a minor quantity of oxygen.

The relationship between the temperature and the resistivity of the resultant material in tablet form was investigated. It was observed that the phase transition to a superconducting state began as the temperature descended below 109°K (Tc onset temperature) and the disappearance of resistance was observed at 75°K (Tco).

### Example 2:

ZrO₂, BaCO₃, and CuO all in the form of fine powder having a purity of 99.95% or higher were mixed in the proportions required by the above formula (i) with x=0.66 (A:B=1:2); y=3.0; z=3.0; w=6 to 8 and with A being Zr and B being barium. The procedure described in Example 1 was followed with this alternative mixture.

The relationship between the temperature and the resistivity of the resultant material in tablet form was investigated. The phase transition to superconductivity was observed with the temperature descended below 80°K (Tc onset temperature) and the disappearance of resistance was observed at 63°K (Tco).

### Example 3:

The procedure of Example 1 was repeated but with 20%-30% of Nb substituted by Y (introduced as Y₂O₃). As a result, the Tc onset temperature was elevated by a further 3-9°K.

In general, it is found to be effective for the purpose of elevating Tc to add to the starting materials according to the invention the oxide of one or more elements selected from the group consisting of Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium) and V (Vanadium), as well as Y (Yttrium), such elements being called hereinafter R elements, so that A in the above general formula (i) is partially substituted by the element R. By virtue of this substitution Tc is expected to be elevated by 5-10°K. The oxide of an R element, e.g. Yb₂O₃, may for example be dissolved in an excess potassium sulfate solution to form a double salt of the type R₂(SO₄)K₂SO₄. The resulting solution can be added to the powder obtained when the tablet is ground after the pre-firing step. The proportion of the additive R can be controlled precisely by this procedure. In accordance with experimental results, Tc was elevated by up to 8°K when this procedure was applied to Example 1 so as to introduce Yb into the ceramic composition.

It will of course be appreciated that elements other than those specified in the foregoing Examples, such as Ga or Ge as the element A and Sr as the element B, can be used for forming superconducting ceramics of the general formula (i) according to the present invention.

There will now be described below examples of the manufacture by a process according to the present invention of superconducting ceramic materials according to the stoichiometric formula:

(A₁₋ₓBₓ)_{y}CuO_{z} (ii)

wherein x=0.01-0.3; y=1.3-2.2; and z=2.0-4.0; and wherein A represents one or more elements selected from the group consisting of Ga, Zr, Nb and Ge, and B represents Ba and/or Sr.

The formula (ii) corresponds to superconducting ceramic compositions which appear to have a K₂NiF₄-like structure.

### Example 4:

Nb₂O₅, BaCO₃, and CuO all in the form of fine powder having a purity of 99.95% or higher were mixed in the proportions required by the above formula (ii) with x=0.15; y=2.0; z=2.0-4.0 and with A being Nb and B being barium. These materials were thoroughly mixed in a mortar, packed into capsules and pressed into tablets of 10mm diameter and 3mm thickness under a pressure of 3 Kg/cm². Then, the tablets were fired for 8 hours at 500-1000°C, for example 700°C, in an oxidizing environment, for example ambient air, this step being called pre-firing hereinafter.

The tablets were then ground in a mortar into a powder having an average particle radius of not larger than 10 microns. The powder was again pressed in capsules under a pressure of 50 Kg/cm² at an elevated temperature to form tablets. The tablets were fired for 10-50 hours, e.g. for 15 hours, at 500-1000°C, e.g. 900°C, in an oxidizing environment, e.g. ambient air, this step being called main-firing hereinafter.

The resulting tablets were observed mainly to have a perovskite-like structure, but a K₂NiF₄-type structure was also found at the same time. Finally, the tablets were reduced by heating for 3-30 hours, e.g. for 20 hours, at 600-1100°C, e.g. at 800°C, in an oxygen/argon mixture containing a minor amount of oxygen. After this reduction treatment, the presence of a K₂NiF₄-type structure was conspicuously evident.

The relationship between the temperature and the resistivity of this material in tablet form was investigated. It was observed that the phase transition to the superconducting state began as the temperature descended below 85°K (Tc onset temperature and the disappearance of resistance was observed at 52°K (Tco).

### Example 5:

ZrO₂, BaCO₃, and CuO all in the form of fine powder having a purity of 99.95% or higher were mixed in the proportions required by the above formula (ii) with x=0.15; y=2.0; and z=2 to 4 and with A being Zr and B being barium. The procedure described in Example 4 was followed with this mixture.

The relationship between the temperature and the resistivity of the resultant material in tablet form was investigated. The phase transition to superconductivity was observed to begin when the temperature descended below 53°K (Tc onset temperature) and the disappearance of resistance was observed at 39°K (Tco).

### Example 6:

The procedure of Example 4 was repeated but with 20%-30% of Nb substituted by Y (introduced as Y₂O₃). As a result, the Tc onset temperature was elevated by a further 3-9°K.

In general, it is found to be effective for the purpose of elevating Tc to add to the starting materials according to the invention the oxide of one or more elements selected from the group consisting of Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), and V (Vanadium), as well as Y (Yttrium), namely the previously mentioned R elements, so that A in the above general formula (ii) is partially substituted by the element R. By virtue of this substitution, Tc is expected to be elevated by 5-10°K. The R element may be added in oxide form as previously described herein.

It will of course be appreciated that elements other than those specified in the foregoing Examples 4, 5 and 6, such as Ga, Ge as the element A and Sr as the element B, can be used for forming superconducting ceramics of the general formula (ii) according to the present invention.

While several embodiments have been specifically described, it is to be appreciated that the present invention is not limited to the particular examples described and that modifications and variations can be made without departure from the scope of the invention. For example, although the examples are directed to superconducting tablets, the superconducting ceramics can be formed into thin film.

## Claims

1. A superconducting oxide ceramic represented by the general formula
(A₁₋ₓBₓ)_{y}Cu_{z}O_{w}
wherein x=0.66; y=2.0-4.0; z=1.0-4.0; and w=4.0-10.0; and
wherein A is one or more elements selected from the group consisting of Ga (Gallium), Zr (Zirconium), Nb (Niobium) and Ge (Germanium); and B is one or more elements selected from the alkaline earth metals.

2. The ceramic of claim 1 wherein y=2.5-3.5; z=1.5-3.5; and w=6.0-8.0.

3. The ceramic of claim 1 or 2 wherein a minor proportion of the element represented by A is substituted by one or more elements selected from the group consisting of Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium), and Y (Yttrium).

4. A superconducting oxide ceramic represented by the general formula
(A₁₋ₓBₓ)_{y}CuO_{z}
wherein x=0.01-0.3; y=1.3-2.2; and z=2.0-4.0, and wherein A is one or more elements selected from the group consisting of Ga (Gallium), Zr (Zirconium), Nb (Niobium) and Ge (Germanium); and B is one or more elements selected from the alkaline earth metals.

5. The ceramic of claim 4 wherein B is Ba (Barium) and/or Sr (Strontium).

6. The ceramic of claim 5 or 6 wherein a minor proportion of the element represented by A is substituted by one or more elements selected from the group consisting of Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium) and Y (Yttrium).

7. A method of forming a superconducting oxide ceramic as claimed in any of the preceding claims, said method comprising:
(a) mixing oxides or carbonates of copper, of one or more alkaline earth metals, and of one or more elements selected from the group consisting of Ga, Zr, Nb and Ge in the respective proportions required to form the superconducting oxide ceramic;
(b) compacting the mixture under pressure;
(c) firing the compact mixture;
(d) grinding the fired mixture into powder; and
(e) forming a superconducting oxide ceramic from said powder.

8. The method of claim 7 wherein said superconducting oxide ceramic forming process (e) comprises the steps of compacting said powder and firing the compacted powder.

9. The method of claim 8 wherein both the firing processes of steps (c) and (e) are carried out at 500-1000°C.

10. The method of claim 8 or 9 wherein both the firing processes of steps (c) and (e) are carried out in an oxidizing atmosphere.

11. The method of claim 10 further comprising, after the later firing of step (e), a step of heating the fired compact in a reducing atmosphere.

12. The method of claim 11 wherein said heating process is carried out at 600-1100°C.

## Patentansprüche

1. Supraleitende Oxidkeramik, die durch die folgende allgemeine Formel wiedergegeben wird:
(A₁₋ₓBₓ)_{y}Cu_{z}O_{w,}
mit x = 0,66; y = 2.0-4.0, z = 1.0-4.0 und w = 4.0-10.0; und
wobei A eines oder mehrere Elemente aus der Gruppe mit Ga (Gallium), Zr (Zirkonium), Nb (Niob) und Ge (Germanium) ist, und B eines oder mehrere Elemente der Erdalkalimetalle ist.

2. Keramik nach Anspruch 1, bei der y = 2.5-3.5; z = 1.5-3.5 und w = 6.0-8.0 ist.

3. Keramik nach Anspruch 1 oder 2, bei der ein geringer Anteil des durch A repräsentierten Elementes durch eines oder mehrere Elemente aus der Gruppe mit Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium) und Y (Yttrium) ersetzt ist.

4. Supraleitende Oxidkeramik, die durch die folgende allgemeine Formel repräsentiert wird
(A₁₋ₓBₓ)_{y}CuO_{z,}
mit x = 0.01-0.3; y = 1.3-2.2 und z = 2.0-4.0; und
wobei A eines oder mehrere Elemente aus der Gruppe mit Ga (Gallium), Zr (Zirkonium), Nb (Niob) und Ge (Germanium) ist und B eines oder mehrere Elemente der Erdalkalimetalle ist.

5. Keramik nach Anspruch 4, bei der B Ba (Barium) und/oder Sr (Strontium) ist.

6. Keramik nach Anspruch 5 oder 6, bei der ein geringer Anteil des durch A repräsentierten Elementes durch eines oder mehrere Elemente aus der Gruppe mit Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium) und Y (Yttrium) ersetzt ist.

7. Verfahren zum Herstellen einer supraleitenden Oxidkeramik, wie sie durch einen der vorstehenden Ansprüche beansprucht wird, welches Verfahren folgendes aufweist:
(a) Vermischen von Oxiden oder Karbonaten von Kupfer, einem oder mehreren Erdalkalimetallen und einem oder mehreren Elementen aus der Gruppe mit Ga, Zr, Nb und Ge in den jeweils zum Ausbilden der supraleitenden Oxidkeramiken erforderlichen Verhältnissen;
(b) Verdichten der Mischung unter Druck;
(c) Brennen der verdichteten Mischung;
(d) Mahlen der gebrannten Mischung zu einem Pulver; und
(e) Herstellen einer supraleitenden Oxidkeramik aus dem Pulver.

8. Verfahren nach Anspruch 7, bei dem der Prozeß (e) zum Herstellen der supraleitenden Oxidkeramik die Schritte des Verdichtens des Pulvers und des Brennens des verdichteten Pulvers umfaßt.

9. Verfahren nach Anspruch 8, bei dem beide Brennprozesse der Schritte (c) und (e) bei 500 - 1000°C ausgeführt werden.

10. Verfahren nach Anspruch 8 oder 9, bei dem beide Brennprozesse der Schritte (c) und (e) in oxidierender Atmosphäre ausgeführt werden.

11. Verfahren nach Anspruch 10, zu dem weiterhin nach dem späteren Brennen im Schritt (e) ein Schritt des Beheizens des gebrannten, verdichteten Materials in reduzierender Atmosphäre gehört.

12. Verfahren nach Anspruch 11, bei dem der Heizprozeß bei 600 - 1100°C ausgeführt wird.

## Revendications

1. Matière céramique de type oxyde supraconductrice, représentée par la formule générale :
(A₁₋ₓBₓ)_{y}Cu_{z}O_{w}
dans laquelle :
- x = 0,66 ;
- y = 2,0-4,0 ;
- z = 1,0-4,0 ; et
- w = 4,0-10,0 ; et
dans laquelle :
- A représente un ou plusieurs éléments choisis dans le groupe constitué par Ga (Gallium), Zr (Zirconium), Nb (Niobium) et Ge (Germanium) ; et
- B représente un ou plusieurs éléments choisis parmi les métaux alcalino-terreux.

2. Matière céramique selon la revendication 1, dans laquelle :
- y = 2,5-3,5 ;
- z = 1,5-3,5 ; et
- w = 6,0-8,0.

3. Matière céramique selon la revendication 1 ou 2, dans laquelle une proportion mineure de l'élément représenté par A est remplacée par un ou plusieurs éléments choisis dans le groupe constitué par Eu (Europium), Gd (Gadolinium), Tb (Terbium), Dy (Dysprosium), Ho (Holmium), Er (Erbium), Tm (Thulium), Yb (Ytterbium), Lu (Lutetium), Sc (Scandium), V (Vanadium) et Y (Yttrium).

4. Matière céramique de type oxyde supraconductrice représentée par la formule :
(A₁₋ₓBₓ)_{y}CuO_{z}
dans laquelle :
- x = 0,01-0,3 ;
- y = 1,3-2,2 ; et
- z = 2,0-4,0 ; et
dans laquelle :
- A représente un ou plusieurs éléments choisis dans le groupe constitué par Ga (Gallium), Zr (Zirconium), Nb (Niobium) et Ge (Germanium) ; et
- B représente un ou plusieurs éléments choisis parmi les métaux alcalino-terreux.

5. Matière céramique selon la revendication 4, dans laquelle B représente Ba (Baryum) et/ou Sr (Strontium).

6. Matière céramique selon la revendication 5 ou 6, dans laquelle une proportion mineure de l'élément représenté par A est remplacée par un ou plusieurs éléments choisis dans le groupe constitué par Eu (Europium), Gd (Gadolinium), Tb (Terbium), Dy (Dysprosium), Ho (Holmium), Er (Erbium), Tm (Thulium), Yb (Ytterbium), Lu (Lutétium), Sc (Scandium), V (Vanadium) et Y (Yttrium).

7. Procédé de formation d'une matière céramique de type oxyde supraconductrice, telle que définie à l'une quelconque des revendications précédentes, ledit procédé comprenant :
(a) le mélange d'oxydes de carbonate de cuivre, d'un ou plusieurs métaux alcalino-terreux, et d'un ou plusieurs éléments choisis dans le groupe constitué par Ga, Zr, Nb et Ge, dans les proportions respectives requises pour former la matière céramique de type oxyde supraconductrice;
(b) le compactage du mélange sous pression ;
(c) la cuisson du mélange compact ;
(d) le broyage en une poudre du mélange cuit ; et
(e) la formation d'une matière céramique de type oxyde supraconductrice à partir de ladite poudre.

8. Procédé selon la revendication 7, dans lequel ledit procédé (e) de formation de la matière céramique de type oxyde supraconductrice comprend les étapes de compactage de ladite poudre et de cuisson de la poudre compactée.

9. Procédé selon la revendication 8, dans lequel les procédés de cuisson des étapes (c) et (e) sont tous deux effectués à 500-1000°C.

10. Procédé selon la revendication 8 ou 9, dans lequel les procédés des étapes (c) et (e) sont tous deux effectués dans une atmosphère oxydante.

11. Procédé selon la revendication 10, comprenant en outre, après la dernière cuisson de l'étape (e), une étape de chauffage du comprimé cuit, dans une atmosphère réductrice.

12. Procédé selon la revendication 11, dans lequel ledit procédé de chauffage est effectué à 600-1100°C.
